# DEMANDE DE BREVET EUROPEEN

(11) **EP 0 668 509 A1**
(43) Date de publication de la demande: **23.08.1995**
(21) Numéro de dépôt: 95400339.8
(22) Date de dépôt: 17.02.1995
(51) Int. Cl.: G01R 29/027

(54) **Procédé et dispositif pour mesurer la gigue d'un signal numérique**

(30) Priorité: 21.02.1994 FR 9401931
(71) Demandeur: AUDIO VISUEL SYSTEMES, Société Anonyme dite:, F-93100 Montreuil Sous Bois (FR)
(72) Inventeur: Martin, Bruno Jean-Marie, F-77600 Chanteloup en Brie (FR)
(74) Mandataire: Bonnetat, Christian

(57) **Abrégé**

La présente invention concerne un procédé et un dispositif (1) pour déterminer la gigue d'un signal numérique, notamment utilisé dans le domaine de la télévision.

Selon l'invention, ledit dispositif (1) comporte :
- un séquenceur (8) déterminant une fenêtre temporelle récurrente ;
- un convertisseur temps amplitude (2) engendrant des rampes de mesure en fonction de la position des transitions positives dudit signal numérique par rapport à ladite fenêtre temporelle récurrente ;
- un convertisseur analogique numérique (4) convertissant les amplitudes desdites rampes de mesure en valeurs numériques ; et
- un système de traitement numérique (6) déterminant la gigue du signal à partir desdites valeurs numériques.

## Description

La présente invention concerne un procédé et un dispositif pour mesurer la gigue d'un signal numérique.

Quoique non exclusivement, la présente invention sera plus particulièrement appliquée à la mesure de la gigue d'un signal vidéo numérique série.

On sait que l'introduction de la technologie numérique dans le domaine de la télévision a posé de nouveaux problèmes, en particulier en ce qui concerne la mesure du signal utilisé. En effet, il s'est avéré nécessaire de trouver des instruments de mesure susceptibles de mesurer toutes les caractéristiques nouvelles importantes. Parmi ces caractéristiques importantes du signal, le paramètre de gigue, qui représente un signal de bruit correspondant à une modulation de phase du signal d'horloge, est l'un des plus difficiles à mesurer, surtout en raison du domaine de fréquences utilisé.

De façon usuelle, on mesure ladite gigue à partir d'un oscilloscope, ce qui présente de nombreux inconvénients. En particulier, le prix d'un tel oscilloscope est extrêmement élevé, surtout par rapport à l'utilisation envisagée. En outre, un tel oscilloscope ne permet pas de mesurer la gigue d'un signal au cours d'une ligne vidéo, tel que nécessaire en particulier dans le domaine de la télévision numérique.

Aussi, la présente invention a pour objet de remédier à ces inconvénients. Elle concerne un procédé permettant de mesurer, de façon précise et directe, sans l'utilisation d'un oscilloscope, la gigue d'un signal numérique, en particulier un signal numérique utilisé dans le domaine de la télévision numérique et situé généralement dans une gamme comprise entre 140 et 300 Mbits.

A cette fin, selon l'invention, le procédé pour déterminer la gigue d'un signal numérique, est remarquable en ce que :
- on détermine une fenêtre temporelle récurrente ;
- à chaque récurrence de ladite fenêtre temporelle, on engendre une rampe de mesure dont l'amplitude croît proportionnellement à la durée entre le début de ladite récurrence et la première transition positive du signal numérique dans ladite récurrence ;
- on convertit l'amplitude des rampes de mesure obtenues à la fin desdites récurrences de la fenêtre temporelle en valeurs numériques ; et
- à partir des valeurs numériques ainsi obtenues, on détermine la gigue dudit signal.

Ainsi, la difficulté de mesure directe de la gigue est résolue, selon l'invention, en transformant les durées nécessaires pour la détermination de la gigue en rampes de mesure dont les amplitudes peuvent être facilement mesurées et converties en valeurs numériques. Il suffit alors d'exploiter ces valeurs numériques pour obtenir la gigue recherchée.

Selon l'invention, pour déterminer la gigue du signal à partir desdites valeurs numériques :
- on définit la première valeur numérique obtenue comme valeur de référence ;
- pour chaque valeur numérique suivante :
   . on compare ladite valeur numérique à la valeur de référence actuelle ; et
   . si ladite valeur numérique est inférieure à ladite valeur de référence actuelle, on définit ladite valeur numérique comme nouvelle valeur de référence ; sinon, on soustrait la valeur de référence actuelle à ladite valeur numérique ;
- on compare entre elles les différences ainsi calculées ; et
- on définit, comme valeur crête à crête de la gigue du signal, la différence la plus importante en valeur absolue.

Ainsi, on est en mesure de déterminer la gigue à la fin d'une ligne vidéo, comme l'exige la surveillance d'un signal vidéo utilisé dans le domaine d'une télévision à technologie numérique, en prenant simplement en compte la différence maximale obtenue au cours d'une telle ligne vidéo.

La présente invention concerne également un dispositif pour la mise en oeuvre du procédé décrit précédemment.

Selon l'invention, ledit dispositif comporte :
- un séquenceur, déterminant à partir du signal numérique à analyser une fenêtre temporelle récurrente et différentes horloges destinées à commander le fonctionnement dudit dispositif ;
- un convertisseur temps amplitude relié audit séquenceur, recevant le signal numérique à analyser, et engendrant des rampes de mesure en fonction de la position des transitions positives dudit signal numérique par rapport à ladite fenêtre temporelle récurrente ;
- un convertisseur analogique numérique relié audit convertisseur temps amplitude et convertissant les amplitudes desdites rampes de mesure en valeurs numériques ; et
- un système de traitement numérique relié audit convertisseur analogique numérique et déterminant la gigue du signal à partir desdites valeurs numériques.

Avantageusement, ledit convertisseur temps amplitude est un intégrateur muni d'au moins une capacité devant être chargée.

Le dispositif conforme à l'invention comporte, par ailleurs, de façon avantageuse, un dispositif d'asservissement associé audit convertisseur temps amplitude et permettant de modifier l'amplitude des rampes de mesure en fonction des valeurs numériques déterminées par le convertisseur analogique numérique, ce qui permet d'adapter lesdites rampes à l'entrée dudit convertisseur analogique numérique et également d'éliminer les rampes d'amplitudes extrêmes sources de perturbations.

A cet effet, avantageusement, ledit dispositif d'asservissement est susceptible de modifier le courant de charge de ladite capacité du convertisseur temps amplitude.

De façon avantageuse, ledit dispositif d'asservissement est commandé par des signaux d'asservissement définis en fonction de l'amplitude d'une rampe de calibration par rapport à deux valeurs d'amplitude déterminées, afin de centrer les rampes par rapport à l'entrée du convertisseur analogique numérique, et/ou par des signaux d'asservissement définis en fonction de l'amplitude des rampes de mesure par rapport à au moins une valeur d'amplitude déterminée.

En outre, ledit système de traitement numérique comporte avantageusement :
- un calculateur recevant lesdites valeurs numériques à analyser, définissant une valeur de référence et calculant la différence entre lesdites valeurs numériques et ladite valeur de référence ;
- un comparateur comparant entre elles les différences ainsi calculées ; et
- une mémoire enregistrant la différence la plus importante en valeur absolue, déterminée au cours d'une série de mesures, par exemple au cours d'une ligne vidéo dans le cas d'une télévision, et communiquant ce résultat.

Afin de n'avoir à traiter que les valeurs numériques intéressantes pour la détermination de la gigue, de façon avantageuse, ledit système de traitement numérique comporte de plus un système de filtrage, agencé en amont dudit calculateur dans le sens de transmission des informations, et comportant :
- une mémoire enregistrant la plus petite valeur numérique obtenue lors d'une série de mesures précédentes ;
- un moyen de calcul faisant la somme de cette plus petite valeur numérique et d'une valeur déterminée ; et
- un moyen de comparaison comparant toutes les valeurs numériques déterminées par ledit convertisseur analogique numérique à ladite somme et ne communiquant audit calculateur pour leur analyse que les valeurs inférieures à ladite somme.

Les figures du dessin annexé feront bien comprendre comment l'invention peut être réalisée. Sur ces figures, des références identiques désignent des éléments semblables.

La figure 1 est le schéma synoptique d'un dispositif conforme à l'invention.

La figure 2 illustre différents signaux d'horloge utilisés pour la détermination de la gigue.

La figure 3 montre de façon schématique un convertisseur temps amplitude faisant partie du dispositif conforme à l'invention.

La figure 4 illustre des signaux d'horloge, ainsi que des rampes de mesure et de calibration associées temporellement à ces signaux.

La figure 5 montre, de façon agrandie, les rampes de mesure de la figure 4.

La figure 6 montre, de façon agrandie, la rampe de calibration de la figure 4.

La figure 7 illustre schématiquement un dispositif d'asservissement faisant partie du dispositif conforme à l'invention.

La figure 8 est le schéma synoptique d'un système de traitement numérique conforme à l'invention.

La figure 9 est le schéma synoptique d'un système de filtrage faisant partie du système de traitement numérique de la figure 8.

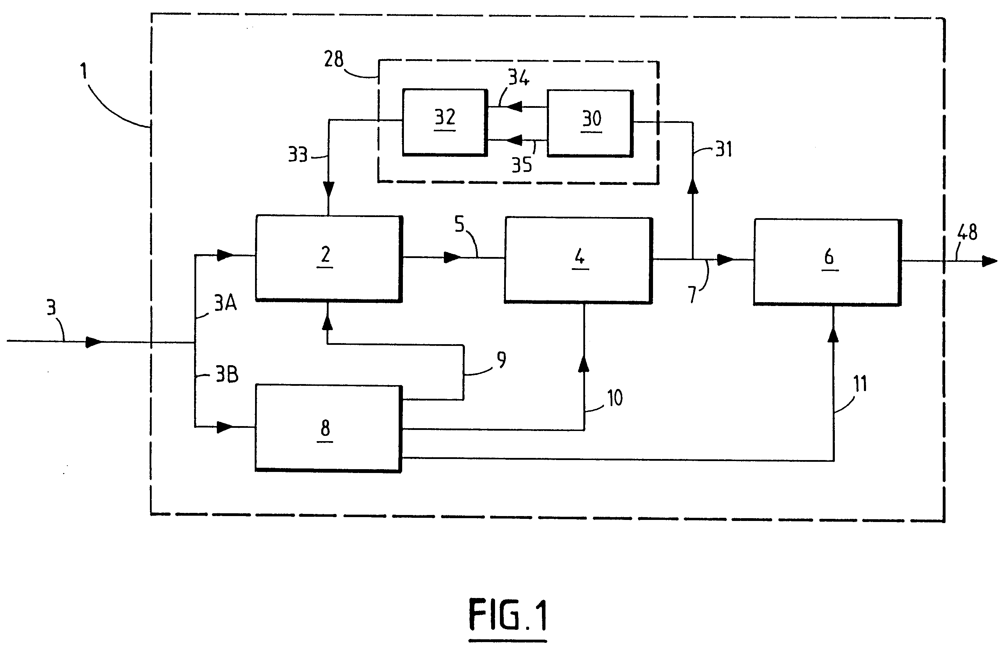

Le dispositif 1 conforme à l'invention et représenté sur la figure 1 est destiné à mesurer la gigue d'un signal numérique, en particulier un signal vidéo numérique série tel qu'utilisé dans le domaine de la télévision numérique.

A cet effet, ledit dispositif 1 comporte :
- un convertisseur temps amplitude 2, recevant le signal numérique à analyser, par l'intermédiaire d'une liaison 3A qui correspond à l'une de deux branches 3A et 3B d'une liaison dédoublée 3 transmettant ledit signal numérique ;
- un convertisseur analogique numérique 4 relié par l'intermédiaire d'une liaison 5 audit convertisseur temps amplitude 2 ;
- un système de traitement numérique 6 relié par l'intermédiaire d'une liaison 7 audit convertisseur analogique numérique 4 ; et
- un séquenceur 8 recevant ledit signal numérique à analyser par l'intermédiaire de la liaison 3B et relié audit convertisseur temps amplitude 2, audit convertisseur analogique numérique 4 et audit système de traitement numérique 6, respectivement par l'intermédiaire de liaisons 9, 10 et 11, chacune desdites liaisons 9, 10 et 11 étant susceptible de transmettre plusieurs signaux de façon séparée.

Ledit séquenceur 8 comporte un oscillateur (non représenté), par exemple à quartz, asservi en phase sur le signal d'entrée et déterminant une horloge stabilisée qui présente une fréquence correspondant par exemple au dixième de la fréquence dudit signal d'entrée.

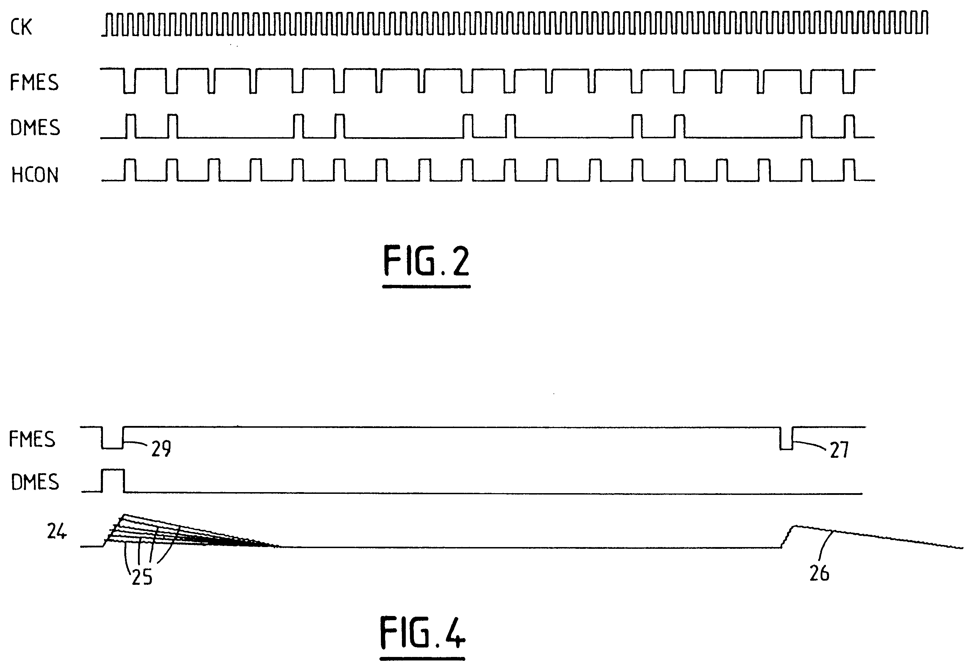

A partir de cette horloge stabilisée, ledit séquenceur 8 définit différentes horloges utilisées comme on le verra ci-après pour commander les différents éléments du dispositif 1, et représentées sur la figure 2.

Sur la figure 2, on a ainsi représenté :
- un signal CK correspondant au signal de l'horloge stabilisée ;
- un signal FMES correspondant à une fenêtre temporelle récurrente pour la mesure de la gigue ;
- un signal DMES associé audit signal FMES ; et
- un signal HCON correspondant au signal d'horloge du convertisseur analogique numérique 4.

Ledit séquenceur 8 transmet les signaux FMES et DMES au convertisseur temps amplitude 2 par l'intermédiaire de la liaison 9.

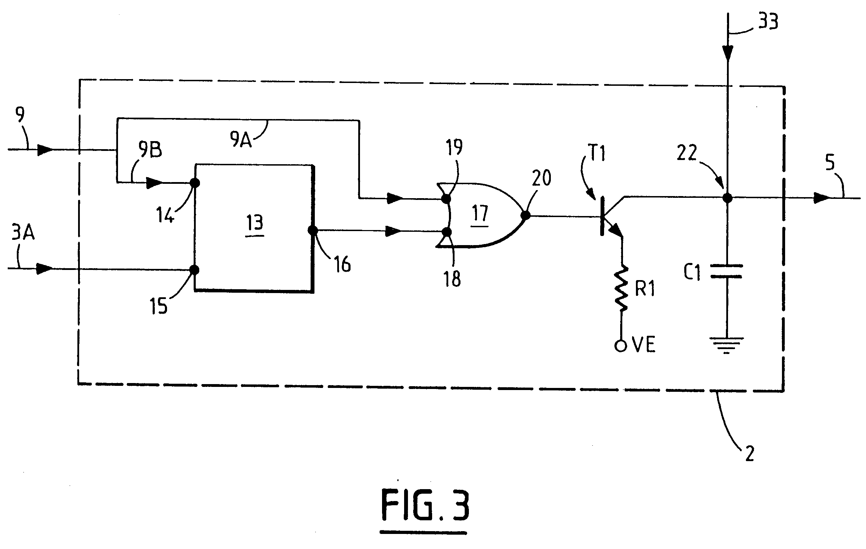

Ledit convertisseur temps amplitude 2 représenté sur la figure 3 comporte :
- une bascule 13 à deux entrées 14 et 15 et à une sortie 16 ;
- une porte logique OU 17 reliée par l'une 18 de ses entrées à ladite sortie 16 de la bascule 13 et, par l'autre entrée 19, à une liaison 9A correspondant à l'une de deux branches 9A et 9B de la liaison 9 dédoublée, chacune desdites branches 9A et 9B transmettant un signal particulier comme on le verra ci-après ;
- un transistor T1 de type NPN relié, par la base à ladite sortie 20 de la porte logique OU 17, par l'émetteur à une résistance R1 raccordée en outre à une tension fixe VE, et par le collecteur à un point 22 ; et
- une capacité C1 reliée, d'une part audit point 22 et, d'autre part, à la masse, la tension de ladite capacité C1 pouvant être mesurée par l'intermédiaire de la liaison 5 reliée audit point 22.

La bascule 13 reçoit à son entrée 15, à laquelle est reliée la liaison 3A, le signal numérique à analyser et à son entrée 14, à laquelle est reliée la liaison 9B, le signal DMES qui correspond au signal D de la bascule 13.

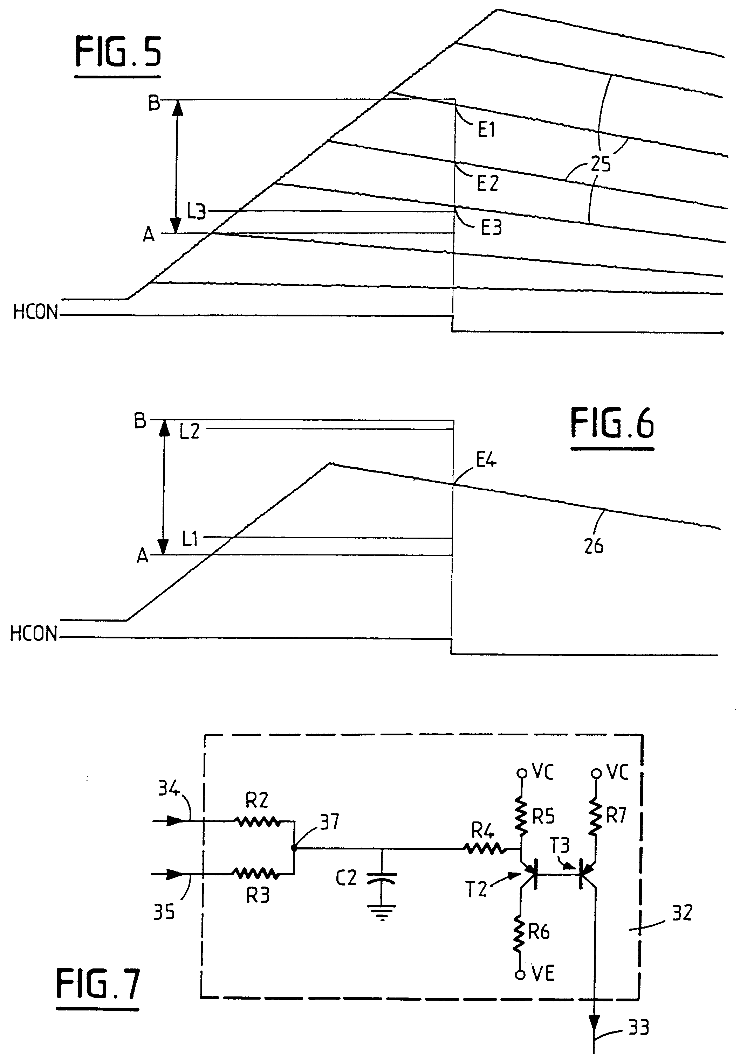

La première transition positive du signal numérique, lorsque le signal DMES est au niveau haut, provoque un changement d'état à la sortie 16 de la bascule 13 qui passe du niveau bas au niveau haut. Le signal à la sortie 16, combiné par la porte logique OU 17 au signal FMES correspondant à la fenêtre temporelle de mesure et transmis par la liaison 9A, engendre une impulsion dont la durée est variable en fonction de la position de la transition par rapport auxdits signaux DMES et FMES. Cette impulsion est intégrée par l'intermédiaire du transistor T1 et de la capacité C1 de sorte que l'on obtienne au point 22 un signal 24, représenté sur la figure 4 en correspondance temporelle desdits signaux DMES et FMES, et comportant des rampes de mesure 25 et une rampe de calibration 26, lesquelles rampes 25 et 26 sont représentées de façon agrandie respectivement sur les figures 5 et 6.

La rampe de calibration 26 est engendrée à partir d'une impulsion 27 du signal FMES de demi-durée par rapport à une impulsion 29 correspondant à la fenêtre temporelle effective telle que définie conformément à l'invention.

Ledit signal 24 est transmis au convertisseur analogique numérique 4.

Au front descendant du signal HCON, correspondant au signal d'horloge du convertisseur analogique numérique 4 et partiellement représenté sur les figures 5 et 6, les amplitudes desdites rampes 25 et 26 sont converties en valeurs numériques E1, E2, E3 et E4 par ledit convertisseur analogique numérique 4.

Les valeurs numériques E1, E2 et E3 desdites rampes de mesure 25 sont transmises au système de traitement numérique 6 qui, à partir de ces valeurs numériques, détermine la gigue du signal numérique, comme on le verra ci-après.

Le dispositif 1 conforme à l'invention comporte en outre un dispositif d'asservissement 28 destiné à ajuster les amplitudes des rampes de manière :
- que la valeur E4 de la rampe de calibration 26 soit comprise entre deux valeurs déterminées L1 et L2, elles-mêmes comprises entre des valeurs A et B correspondant respectivement aux seuils extrêmes inférieur et supérieur d'entrée du convertisseur analogique numérique 4 ; et
- que la valeur minimale E3 (comprise entre A et B) des différentes rampes de mesure fluctue autour d'une valeur déterminée L3.

A cet effet, selon l'invention, ledit dispositif d'asservissement 28 comporte, tel que représenté sur la figure 1 :
- un système de comparaison 30, relié par l'intermédiaire d'une liaison 31 à la sortie du convertisseur analogique numérique 4, comparant d'une part E4 à L1 et L2 et, d'autre part, E3 à L3, et déterminant en fonction de cette comparaison deux signaux d'asservissement AS1 et AS2 susceptible de prendre à chaque fois l'une de deux valeurs 0 ou 1 ; et
- un système à courant de charge 32 relié au point 22 du convertisseur temps amplitude 2 par l'intermédiaire d'une liaison 33 et destiné à modifier le courant de charge de la capacité C1 en fonction de la valeur des signaux d'asservissement AS1 et AS2 qui lui sont transmis respectivement par l'intermédiaire de liaisons 34 et 35.

Pour modifier le courant de charge, ledit système à courant de charge 32 comporte, conformément à l'invention et comme représenté sur la figure 7, deux résistances R2 et R3 montées en parallèle, reliées respectivement aux liaisons 34 et 35 et présentant un point commun 37, auquel sont reliées une capacité C2 raccordée en outre à la masse et une résistance R4.

Ladite résistance R4 est reliée, d'une part à une résistance R5 raccordée à une tension fixe VC et, d'autre part, à l'émetteur d'un transistor T2 de type PNP, dont le collecteur est relié à une résistance R6 raccordée à une tension fixe VE, et dont la base est reliée à la base d'un transistor T3, également de type PNP.

L'émetteur dudit transistor T3 est relié à une résistance R7 raccordée à la tension VC et le collecteur dudit transistor T3 est relié à la liaison 33.

La réponse dudit système à courant de charge 32 transmise par la liaison 33 est adaptée aux signaux AS1 et AS2 entrés par les liaisons 34 et 35 et elle modifie en correspondance le courant de charge de la capacité C1, pour obtenir les résultats mentionnés ci-dessus.

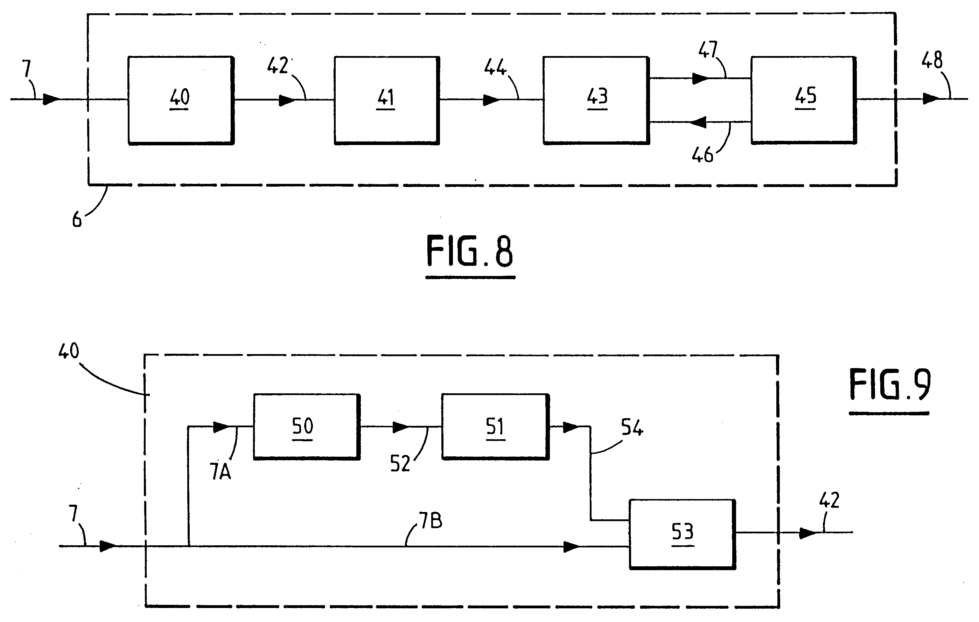

Les valeurs numériques E1, E2, E3 des rampes de mesure 25 sont exploitées par le système de traitement numérique 6 représenté sur la figure 8 et comportant :
- un système de filtrage 40, relié au convertisseur analogique numérique 4 par la liaison 7, filtrant les valeurs numériques et ne retenant que certaines desdites valeurs pour le calcul, comme on le verra de façon plus précise ci-après ;
- un calculateur 41 qui est relié par une liaison 42 audit système de filtrage 40, ledit calculateur 41 effectuant les opérations suivantes :
   . il définit la première valeur obtenue lors d'une série de mesures, par exemple une ligne vidéo, comme valeur de référence Er et enregistre cette valeur dans une mémoire associée non représentée ;
   . pour chaque valeur numérique suivante E, il compare ladite valeur numérique E à la valeur de référence actuelle Er ; et
   . si ladite valeur E est inférieure à ladite valeur de référence actuelle Er, il définit ladite valeur E comme nouvelle valeur de référence Er et il l'enregistre dans ladite mémoire ; sinon, il calcule la différence E-Er ; et
- un comparateur 43 relié par une liaison 44 audit calculateur 41, comparant toutes les différences |E-Er| en valeur absolue, transmises par ledit calculateur 41, à une différence |E-Er|max enregistrée dans une mémoire 45 qui lui transmet cette valeur par une liaison 46.

Ledit comparateur 43 transmet la différence la plus importante, par l'intermédiaire d'une liaison 47, à ladite mémoire 45 qui enregistre cette valeur à la place de la valeur déjà enregistrée si elle est différente de cette dernière, ou qui, dans le cas contraire, garde en mémoire la valeur déjà enregistrée.

Le maximum ainsi obtenu sur une ligne correspond à la valeur crête à crête de la gigue du signal numérique analysé.

Ladite mémoire 45 peut communiquer cette valeur par l'intermédiaire d'une liaison 48, correspondant à la sortie du dispositif 1 conforme à l'invention.

On notera que la comparaison entre les valeurs numériques E et la valeur de référence Er peut être effectuée, soit directement par ledit calculateur 41, soit par un moyen de comparaison associé audit calculateur 41, ledit moyen de comparaison pouvant être un comparateur existant déjà dans le dispositif 1 conforme à l'invention, comme par exemple le comparateur 43 ou un comparateur du système de filtrage 40 décrit ci-après, ou pouvant être un comparateur spécifique non représenté agencé spécialement à cet effet.

Bien évidemment, d'autres systèmes peuvent être raccordés à ladite liaison 48 et être directement intégrés au dispositif 1 conforme à l'invention, comme par exemple un système pour calculer à des intervalles de temps constants la moyenne des valeurs déterminées à la fin de plusieurs lignes successives.

Le système de filtrage 40 destiné à ne retenir que les valeurs intéressantes pour le calcul de la gigue et représenté sur la figure 9 comporte :
- une mémoire 50 enregistrant la plus petite valeur numérique obtenue lors d'une série de mesures précédentes, par exemple lors de la ligne vidéo précédente, ladite mémoire 50 étant reliée à l'une 7A de deux branches 7A et 7B de la liaison 7 ;
- un moyen de calcul 51 relié par une liaison 52 à ladite mémoire 50 faisant la somme de cette plus petite valeur numérique et de la valeur L3 ; et
- un moyen de comparaison 53 relié par une liaison 54 audit moyen de calcul 51, comparant toutes les valeurs numériques transmises par la liaison 7B à ladite somme et ne communiquant audit calculateur 41 pour leur analyse que les valeurs inférieures à ladite somme.

On notera que différents éléments dudit système de traitement numérique 6 sont commandés par le séquenceur 8 par l'intermédiaire de la liaison 11 qui, à cet effet, est divisée, de façon correspondante, en plusieurs branches non représentées raccordées respectivement auxdits éléments à commander.

## Revendications

1. Procédé pour déterminer la gigue d'un signal numérique, caractérisé en ce que :
- on détermine une fenêtre temporelle récurrente (FMES) ;
- à chaque récurrence de ladite fenêtre temporelle (FMES), on engendre une rampe de mesure (25) dont l'amplitude croît proportionnellement à la durée entre le début de ladite récurrence et la première transition positive du signal numérique dans ladite récurrence ;
- on convertit l'amplitude des rampes de mesure (25) obtenues à la fin desdites récurrences de la fenêtre temporelle en valeurs numériques (E1, E2, E3) ; et
- à partir des valeurs numériques ainsi obtenues, on détermine la gigue dudit signal.

2. Procédé selon la revendication 1,
caractérisé en ce que, pour déterminer la gigue du signal à partir desdites valeurs numériques :
- on définit la première valeur numérique obtenue comme valeur de référence ;
- pour chaque valeur numérique suivante :
. on compare ladite valeur numérique à la valeur de référence actuelle ; et
. si ladite valeur numérique est inférieure à ladite valeur de référence actuelle, on définit ladite valeur numérique comme nouvelle valeur de référence ; sinon, on soustrait la valeur de référence actuelle à ladite valeur numérique ;
- on compare entre elles les différences ainsi calculées ; et
- on définit, comme valeur crête à crête de la gigue du signal, la différence la plus importante en valeur absolue.

3. Dispositif (1) pour la mise en oeuvre du procédé spécifié sous l'une des revendications 1 ou 2,
caractérisé en ce qu'il comporte :
- un séquenceur (8), déterminant à partir du signal numérique à analyser une fenêtre temporelle récurrente (FMES) et différentes horloges (CK, DMES, HCON) destinées à commander le fonctionnement dudit dispositif (1) ;
- un convertisseur temps amplitude (2) relié audit séquenceur (8), recevant le signal numérique à analyser, et engendrant des rampes de mesure (25) en fonction de la position des transitions positives dudit signal numérique par rapport à ladite fenêtre temporelle récurrente (FMES) ;
- un convertisseur analogique numérique (4) relié audit convertisseur temps amplitude (2) et convertissant les amplitudes desdites rampes de mesure (25) en valeurs numériques (E1, E2, E3) ; et
- un système de traitement numérique (6) relié audit convertisseur analogique numérique (4) et déterminant la gigue du signal à partir desdites valeurs numériques.

4. Dispositif selon la revendication 3,
caractérisé en ce que ledit convertisseur temps amplitude (2) est un intégrateur muni d'au moins une capacité (C1) devant être chargée.

5. Dispositif selon l'une des revendications 3 ou 4,
caractérisé en ce qu'il comporte un dispositif d'asservissement (28) associé audit convertisseur temps amplitude (2) et permettant de modifier l'amplitude des rampes de mesure (25) en fonction des valeurs numériques (E1, E2, E3) déterminées par le convertisseur analogique numérique (4).

6. Dispositif selon les revendications 4 et 5,
caractérisé en ce que ledit dispositif d'asservissement (28) est susceptible de modifier le courant de charge de ladite capacité (C1) du convertisseur temps amplitude (2).

7. Dispositif selon l'une des revendications 5 ou 6,
caractérisé en ce que ledit dispositif d'asservissement (28) est commandé par des signaux d'asservissement définis en fonction de l'amplitude (E4) d'une rampe de calibration (26) par rapport à deux valeurs d'amplitude déterminées (L1, L2).

8. Dispositif selon l'une des revendications 5 à 7,
caractérisé en ce que ledit dispositif d'asservissement (28) est commandé par des signaux d'asservissement définis en fonction de l'amplitude des rampes de mesure (25) par rapport à au moins une valeur d'amplitude déterminée (L3).

9. Dispositif selon l'une des revendications 3 à 8,
caractérisé en ce que ledit système de traitement numérique (6) comporte :
- un calculateur (41) recevant lesdites valeurs numériques à analyser, définissant une valeur de référence et calculant la différence entre lesdites valeurs numériques et ladite valeur de référence ;
- un comparateur (43) comparant entre elles les différences ainsi calculées ; et
- une mémoire (45) enregistrant la différence la plus importante en valeur absolue et communiquant ce résultat.

10. Dispositif selon la revendication 9,
caractérisé en ce que ledit système de traitement numérique (6) comporte un système de filtrage (40), agencé en amont dudit calculateur (41) dans le sens de transmission des informations, et comportant :
- une mémoire (50) enregistrant la plus petite valeur numérique obtenue lors d'une série de mesures précédentes ;
- un moyen de calcul (51) faisant la somme de cette plus petite valeur numérique et d'une valeur déterminée ; et
- un moyen de comparaison (53) comparant toutes les valeurs numériques déterminées par ledit convertisseur analogique numérique (4) à ladite somme et ne communiquant audit calculateur (41) pour leur analyse que les valeurs inférieures à ladite somme.
